# EUROPÄISCHE PATENTSCHRIFT

(11) **EP 1 303 790 B1**
(45) Veröffentlichungstag und Bekanntmachung des Hinweises auf die Patenterteilung: **28.02.2007**
(21) Anmeldenummer: 01956410.3
(22) Anmeldetag: 25.07.2001
(51) Int. Cl.: G03F 1/00

(54) **VERFAHREN ZUR FESTSTELLUNG DER ABBILDBARKEIT INTEGRIERTER HALBLEITERSCHALTKREISE AUF ALTERNIERENDE PHASENMASKEN**
METHOD FOR DETERMINING THE POSSIBILITY TO ASSIGN IMAGES OF INTEGRATED SEMICONDUCTOR CIRCUITS TO ALTERNATING PHASE SHIFTING MASKS
PROCEDE POUR DETERMINER LA POSSIBILITE DE REPRESENTER DES CIRCUITS SEMI-CONDUCTEURS INTEGRES SUR DES MASQUES A DECALAGE PHASE ALTERNES

(30) Priorität: 26.07.2000 DE 10037444; 20.11.2000 DE 10057437; 20.11.2000 DE 10057438
(43) Veröffentlichungstag der Anmeldung: 23.04.2003
(73) Patentinhaber: Qimonda AG, 81739 München (DE)
(72) Erfinder: LUDWIG, Burkhard, 81379 München (DE); MOUKARA, Molela, 81379 München (DE)
(74) Vertreter: Graf Lambsdorff, Matthias
(86) Internationale Anmeldenummer: PCT/DE2001/002878
(87) Internationale Veröffentlichungsnummer: WO 2002/009152

(56) Entgegenhaltungen:
- US-A- 5 537 648
- US-A- 5 923 566
- MONIWA A ET AL: "HEURISTIC METHOD FOR PHASE-CONFLICT MINIMIZATION IN AUTOMATIC PHASEMASK DESIGN" JAPANESE JOURNAL OF APPLIED PHYSICS, PUBLICATION OFFICE JAPANESE JOURNAL OF APPLIED PHYSICS. TOKYO, JP, Bd. 34, Nr. 12B, 1. Dezember 1995 (1995-12-01), Seiten 6584-6589, XP000721044 ISSN: 0021-4922 in der Anmeldung erwähnt

## Beschreibung

Die Erfindung betrifft allgemein das Gebiet der Herstellung integrierter Halbleiterschaltkrdise wie VLSI- und ULSI-Schaltkreise mittels photolithographischer Verfahren. Insbesondere bezieht sich die Erfindung dabei auf die Steigerung des Auflösungsvermögens der konventionellen Photolithographie durch Gebrauch von alternierenden Phasenmasken.

Bei der Herstellung von integrierten Halbleiterschaltkreisen werden die den Schaltungselementen zugeordneten Maskenstrukturen auf lichtempfindliche Schichten auf dem Wafer konventioneller Weise optisch abgebildet. Aufgrund der Beugungseffekte ist das Auflösungsvermögen eines derartigen Abbildungssystems begrenzt und Maskenstrukturen mit Abmessungen unter dem reziproken Wert dieses Auflösungsvermögens, die sogenannten kritischen Strukturen, werden verschmiert bzw. unscharf abgebildet. Dies führt zu unerwünschten starken Korrelationen der Schaltungs elemente und damit zu einer Beeinträchtigung der Schältungsfunktionalität.

Diese Schwierigkeiten lassen sich überwinden, indem man den destruktiven Interferenzeffekt von zwei eng benachbarten und kohärenten Lichtstrahlen um 180° verschobener Phasen ausnutzt und wandelt die betroffenen konventionellen Masken in alternierende Phasenmasken um, bei denen jede kritische Struktur mit zwei Phasenschiebern zur Erzeugung der erforderlichen Phasenverschiebung versehen ist.

Die verschiedenen Arten von Phasenmasken sind beispielsweise in dem Buch "Technologie hochintegrierter Schaltungen" von D. Widmann, H. Mader und H. Friedrich, 2. Auflage, Springer-Verlag, S. 135ff. beschrieben. Eine ausführliche Übersicht über die Phasenmaskentechnologie ist in den Publikationen "Improving Resolution in Photolithography with a Phase-Shifting Mask" von M. D. Levenson et al. in IEEE Trans. Electron. Devices 29 (1982), 1828ff. und "Wavefront Engineering for Photolithography" von M. D. Levenson in Physics Today, July 1993, S. 28ff. enthalten.

Der Einsatz von sogenannten starken Phasenmasken, zu denen sowohl die bereits genannten alternierenden Phasenmasken als auch chromlose Phasenmasken gezählt werden, erfordert, daß in jeder betroffenen Ebene die transparenten phasenverschiebenden Strukturen einer von zwei Phasen zugewiesen werden, welche eine,Phasendifferenz Δφ = 180° aufweisen. Dabei müssen die folgenden zwei Fälle unterschieden werden. Bei einer sogenannten Dunkelfeld-Phasenmaske entsprechen durchsichtige Strukturen den Schaltungselementen (z.B. Leiterzüge) und ihnen können Phasen zugewiesen werden, während undurchsichtige Maskenfelder durch mit Chrom bedeckte Gebiete gebildet werden. Bei einer sogenannten Hellfeld-Phasenmaske stellen dagegen die mit Chrom bedeckten undurchsichtigen Gebiete der Phasenmaske die Schaltungselemente dar und die dazwischenliegenden Gebiete sind durchsichtig. In letzterem Fall müssen geeignete Bereiche in der Nähe der undurchsichtigen Chromgebiete zu phasenverschiebenden Elementen bestimmt werden. Die Erstellung der phasenverschiebenden Elemente erfolgt nach bestimmten, an sich im Stand der Technik bekannten Design-Regeln und ist beispielsweise in der US-PS-5,537,648 beschrieben.

Angesichts der Komplexität moderner Schaltkreise und der Forderung nach zwei um 180° verschobenen phasenverschiebenden Elementen an jeder kritischen Struktur sind jedoch Phasenkonflikte denkbar. Ein Phasenkonflikt liegt genau dann vor, wenn den Phasenschiebern auf beiden Seiten einer kritischen Struktur fälschlicherweise dieselbe Phase zugewiesen wird, oder wenn aufgrund der Wechselwirkung der phasenverschiebenden Elemente der destruktive Interferenzeffekt an einer unerwünschten Stelle auf der schon erwähnten lichtempfindlichen Schicht auftritt. Die Phasenzuweisung für die verschiedenen phasenverschiebenden Elemente stellt somit ein mathematischkombinatorisches Problem dar, welches nicht allgemein lösbar ist. Da die Phasenzuweisung im Prinzip zu verschiedenen Ergebnissen führen kann und für ein und dieselbe Zelle eines hierarchischen Layouts verschiedene Phasenzuweisungen erfolgen können, muß die Phasenzuweisung in einem automatisierten Programm endgültig am fertigen Schaltkreis-Layout vorgenommen werden. Man benötigt daher eine automatisierte Überprüfungsroutine, welche ein Schaltkreis-Layout daraufhin untersucht, ob eine Phasenzuweisung überhaupt möglich ist. Diese Überprüfung soll vollständig sein und die Problemstelle so gut als möglich eingrenzen, d.h.,ihren eigentlichen Ursprungsort ermitteln. Letzteres ist nicht selbstverständlich, denn wenn die kombinatorische Aufgabe "nicht aufgeht", dann ist dies auf vielfältige Weise möglich und die Stelle, an der man entdeckt, daß dies der Fall ist, kann weit ab von dem eigentlichen Ursprungsort liegen.

Nachdem Phasenkonflikte in einer automatisierten Routine festgestellt worden sind, können diese auf zwei grundsätzlich verschiedene Arten gelöst werden. Zum ersten kann das Schaltkreis-Design an den Stellen der lokalisierten Phasenkonflikte geringfügig verändert werden, beispielsweise durch Verschieben von Leiterbahnstrukturen, so daß die Phasenkonflikte aufgehoben werden. Auf der Basis dieses veränderten Schaltkreis-Designs kann dann eine erfolgreiche Phasenzuweisung für die Erstellung einer Phasenmaske durchgeführt werden. Zum zweiten kann das Schaltkreis-Design unverändert bleiben und statt dessen die Phasenkonflikte dadurch gelöst werden, daß einzelnen phasenverschiebenden Elementen zwei verschiedene Phasen zugewiesen werden. Dies hat jedoch zur Folge, daß an der Grenzlinie zwischen den zwei verschiedenen Phasengebieten eine dunkle Linie bei der Belichtung auftritt, die zu einer Unterbrechung führen würde. Daher muß in diesem Fall ein zusätzlicher Belichtungsschritt mit einer sogenannten TrimMaske durchgeführt werden, durch welchen die'auftretenden dunklen Linien eigens belichtet werden.

Im Stand der Technik sind zwei verschiedene Verfahren zur Überprüfung eines Layouts auf Phasenkonflikte bekannt.

In der Publikation "Heuristic Method for Phase-Conflict Minimization in Automatic Phase-Shift Mask Design" von A. Moniwa et al. in Jpn. J. Appl. Phys., Vol. 34 (1995) S. 6584-6589 (D2), ist ein graphentheoretischer Zugang bekannt, bei welchem ein Satz von phasenverschiebenden Elementen vorausgesetzt wird und aus' diesem Satz ein planarer ungerichteter Graph unter Berücksichtigung der technologischen Anforderungen gebildet wird. In diesem graphentheoretischen Verfahren stellen Graphknoten (Vertices) phasenverschiebende Elemente dar. Eine Graphkante zwischen zwei Knoten bedeutet, daß der Bereich zwischen den dazugehörigen Phasenschiebern lithographisch kritisch ist. Phasenkonflikte' ergeben sich in dieser Methode als diejenigen Zyklen mit ungerader Anzahl von Vertices. Aufgrund der Bedeutung der Graphkanten ist eine Zyklusbrechung, d.h. Lösung eines Phasenkonfliktes äquivalent mit einer Verbreiterung des entsprechenden kritischen Bereiches. Eine effiziente Konfliktlösungsstrategie soll nach dem genannten Verfahren darin bestehen, die in den ungeraden Zyklen am häufigsten auftretenden Kanten zu brechen.

In der US-PS-5,923,566 (D1) wird eine computerimplementierte Routine beschrieben, durch welche verifiziert wird, ob ein vorhandenes Schaltkreis-Design auf eine Phasenmaske abgebildet werden kann oder ob lokalisierte Phasenkonflikte vorhanden sind. Die Phasenkonflikte werden aus der Wechselwirkung von kritischen Schaltkreisgebieten mit den unter Berücksichtigung der technologischen Anforderungen zu bestimmenden zusammenhängenden freien Schaltkreisgebieten erfaßt. Freie Schaltkreisgebiete mit ungerader Anzahl von Wechselwirkungen repräsentieren die Phasenkonflikte.

Beide vorstehend beschriebenen Verfahren arbeiten jedoch nicht optimal in der Erfassung von Phasenkonflikten. Wie' im folgenden noch an Beispielen erläutert werden wird, erweisen sich diese beiden Verfahren zum einen als ineffizient, da bei ihnen beispielsweise bestimmte Phasenkonflikte doppelt angezeigt werden. Zum zweiten erweisen sie sich als unzulänglich, da mit ihnen bestimmte andere Phasenkonflikte nicht erfaßt werden können.

Es ist somit Aufgabe der vorliegenden Erfindung, ein Verfahren zur Feststellung der Abbildbarkeit integrierter Halbleiterschaltkreise auf alternierende Phasenmasken und zur Feststellung möglicher Phasenkonflikte anzugeben, mit welchem unter alleiniger Verwendung der an die Schaltkreisstruktur gestellten technologischen Anforderungen ein vorhandener Satz von Phasenkonflikten vollständig und minimal bestimmt werden kann. Nach der Bestimmung der Phasenkonflikte sollen diese gelöst und ein Layout für eine Phasenmaske erstellt werden.

Diese Aufgabe wird mit den Merkmalen der unabhängigen Patentansprüche 1 und 2 gelöst.

In einem ersten Aspekt der vorliegenden Erfindung wird das erfindungsgemäße Verfahren auf eine Dunkelfeld-Phasenmaske angewandt, wobei also Schaltkreiselemente wie elektrische Leiterbahnen in durchsichtige Bereiche der Phasenmaske abzubilden sind.

Bei diesem Verfahren werden in einem Verfahrensschritt a.) kritische Bereiche bestimmt, in welchen jeweils zwei für die Phasenmaske vorgesehene benachbarte, durchsichtige Bereiche einen bestimmten vorgegebenen Mindestabstand voneinander unterschreiten.

Im nächsten Verfahrensschritt b.) werden Überlappungsbereiche zwischen geraden Abschnitten der erhaltenen kritischen Bereiche und Endbereiche von inmitten von durchsichtigen Bereichen endenden geraden Abschnitten der kritischen Bereiche bestimmt sowie entartete kritische Bereiche generiert. Die letzteren erhält man, indem man Überlappungsbereiche von den kritischen Bereichen abzieht.

In einem weiteren Verfahrensschritt c.) werden dann außerhalb der durchsichtigen und der kritischen Bereiche liegende zusammenhängende Bereiche (Länder) bestimmt, sowie große Außenumrandungen der Länder und der im vorhergehenden Verfahrensschritt erhaltenen Überlappungsbereiche und Endbereiche. Dann wird in einem Verfahrensschritt d.) von jeder der bestimmten Außenumrandungen die Anzahl der Berührungsstrecken mit den entarteten kritischen Bereichen bestimmt und bei ungerader Anzahl ein Phasenkonflikt festgestellt.

In einem zweiten Aspekt der vorliegenden Erfindung wird das erfindungsgemäße Verfahren auf eine,Hellfeld-Phasenmaske angewandt, wobei also Schaltkreiselemente wie elektrische Leiterbahnen in undurchsichtige Bereiche der Phasenmaske abzubilden sind.

Bei diesem Verfahren werden in einem Verfahrensschritt a.) phasenverschiebende Bereiche jeweils beidseits von für die Phasenmaske vorgesehenen undurchsichtigen, kritischen Bereichen bestimmt. Kritische Bereiche werden dadurch definiert, daß sie eine vorgegebene Strukturbreite unterschreiten.

Dann werden in einem Verfahrensschritt b.) Überlappungsbereiche zwischen geraden Abschnitten der kritischen Bereiche und Endbereiche von inmitten von phasenverschiebenden Bereichen oder Wechselwirkungsbereichen zwischen phasenverschiebenden Bereichen endenden geraden Abschnitten der kritischen Bereiche bestimmt sowie entartete kritische Bereiche generiert. Die letzteren erhält man, indem man Überlappungsbereiche von den kritischen Bereichen abzieht.'

In einem Verfahrensschritt c.) werden außerhalb der phasenverschiebenden und kritischen Bereiche liegende zusammenhängende Bereiche (Länder) bestimmt, sowie große Außenumrandungen dieser Länder und der im vorhergehenden Verfahrensschritt erhaltenen Überlappungsbereiche und Endbereiche.

Schließlich werden in einem Verfahrensschritt d.) von jeder der bestimmten Außenumrandungen die Anzahl der Berührungsstrecken mit den entarteten kritischen Bereichen bestimmt und bei ungerader Anzahl, ein Phasenkonflikt festgestell't.

Die vorliegende Erfindung stellt'somit einen Formalismus dar, mittels dessen die direkte Umsetzbarkeit integrierter Halbleiterschatkreise in alternierende Phasenmasken, und zwar sowohl Dunkelfeld- als auch Hellfeld-phasenmasken überprüft werden kann. Dies erfolgt durch eine explizite Lokalisierung der im entsprechenden Layout vorkommenden Phasenkonflikte unter alleiniger Verwendung der an das Design gestellten technologischen Anforderungen. Der mit Hilfe dieses Formalismus bestimmte Satz von Phasenkonflikten ist vollständig und minimal, d.h. es werden stets sämtliche vorhandene Phasenkonflikte ermittelt und vorhandene Phasenkonflikte werden nicht etwa mehrfach angezeigt.

Vorteilhafte Weiterbildungen der erfindungsgemäßen Verfahren sind in den Unteransprüchen dargestellt. Dies betrifft insbesondere Verfahren zur Handhabung derartiger Phasenkonflikte, für die der erfindungsgemäße Formalismus ein optimaler Ausgangspunkt ist. Beispiele derartiger Verfahren sind das auf den bereits erwähnten Trim-Masken basierende, an sich wohlbekannte Verfahren, bei welchem ein weiterer Belichtungsschritt durchgeführt werden muß, die ebenfalls an sich im Stand der Technik bekannte Multiphasen-Maskentechnologie sowie die Festlegung von Änderungen der Layout-Geometrie zur Beseitigung von Layout-Strukturen mit lithographisch kritischen Abmessungen.

Eine weitere günstige Eigenschaft des erfindungsgemäßen Formalismus ist, daß er sich insbesondere für die Implementierung in einem hierarchischen DRC-Tool eignet.

' Das erfindungsgemäße Verfahren ist auch für chromlose Phasenmasken durchaus anwendbar.

Im folgenden wird das erfindungsgemäße Verfahren anhand von Ausführungsbeispielen näher erläutert, bei denen auch Vergleiche mit bereits bekannten Verfahren und deren Ergebnissen gezogen werden. Es zeigen:
- Fig. 1: eine Dunkelfeld-Maske (a.)), anhand des Layouts bestimmte kritische Bereiche, (b.)), die Außenumrandung eines zusammenhängenden Bereichs in dem Layout (c.));
- Fig. 2: die Dunkelfeld-Maske wie in Fig. 1 (a.)), die anhand des Layouts bestimmten kritischen Bereiche (b.)) und die mit den bekannten Verfahren ermittelten Ergebnisse (c.), d.));
- Fig. 3: eine weitere Dunkelfeld-Maske (a.)), die anhand des Layouts der Dunkelfeld-Maske bestimmten kritischen Bereiche (b.)) und die Außenumrandungen der zusammenhängenden Bereiche (c.));
- Fig. 4: eine weitere Dunkelfeld-Maske mit aufeinander stoßenden, in verschiedene Richtungen sich erstreckenden geraden Abschnitten (a.)), zusätzlich eingezeichnetem Überlappungsbereich zwischen den geraden Abschnitten (b.)) und ein vergrößerter kreisförmiger Ausschnitt aus b.) mit einer Außenumrandung um einen Überlappungsbereich, durch die ein Phasenkonflikt signalisiert wird (c.));
- Fig. 5: eine weitere Dunkelfeld-Maske, welche im Vergleich mit Fig. 4 eine zweifache T-Struktur aufweist (a.)), die Maskenstruktur mit zusätzlich eingezeichneten Überlappungsbereichen und Außenumrandungen (b.));
- Fig. 6: eine weitere, einen Endbereich aufweisende Dunkelfeld-Maske (a.) und die Dunkelfeldmaske mit dem kritischen Bereich (schraffiert) und der Umrandung um den Endbereich (b.);

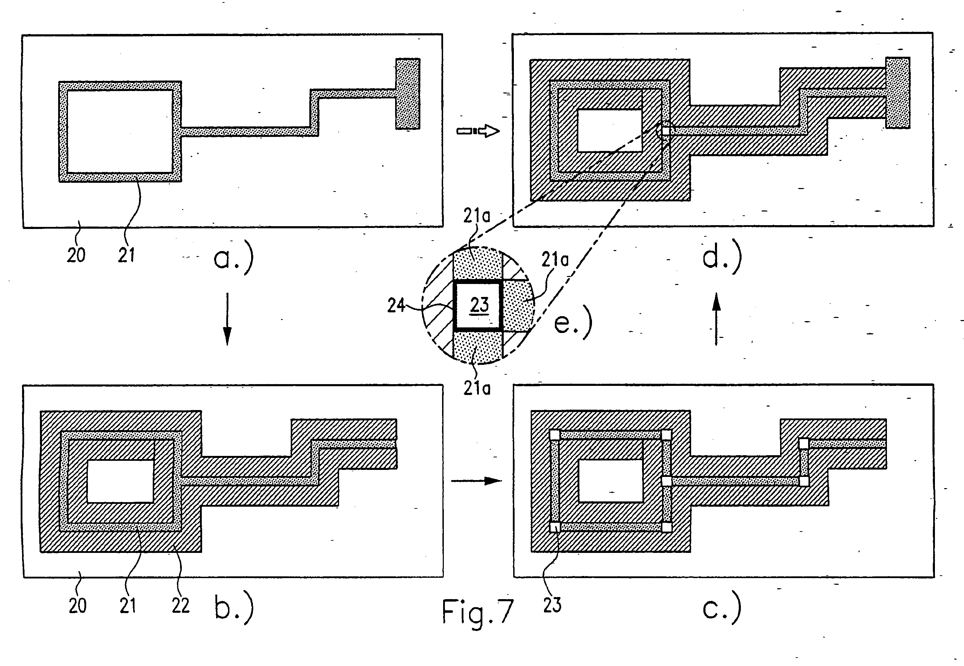

- Fig. 7: eine Hellfeld-Maske (a.)), zusätzlich eingezeichnete phasenschiebende Elemente um die undurchsichtigen, kritischen Strukturbqreiche der Maske (b.)), zusätzlich eingezeichnete Überlappungsbereiche zwischen den geraden Abschnitten der undurchsichtigen, kritischen Strukturbereiche der Maske (c.)), zusätzlich eingezeichnete Außenumrandungen um zusammenhängende Bereiche oder Überlappungsbereiche, durch die sich Phasenkonflikte ergeben (d.)) und ein vergrößerter kreisförmiger Ausschnitt aus d.) mit einer Außenumrandung um einen Überlappungsbereich, durch die ein Phasenkonflikt signalisiert wird (e.));
- Fig. 8: ein weiteres Beispiel für eine erfindungsgemäß zu behandelnde Hellfeld-Maskenstruktur;
- Fig. 9: die Hellfeld-Maske mit zusätzlich eingezeichneten phasenschiebenden Elementen um die undurchsichtigen, kritischen Strukturbereiche;
- Fig. 10a-c: die Hellfeld-Maske der Fig. 9 mit zusätzlich eingezeichneten Überlappungsbereichen (hell) zwischen geraden Abschnitten der undurchsichtigen, kritischen Strukturbereiche (a.)) und vergrößerte kreisförmige Ausschnitte aus a.) zur Definition der Endbereiche (b.), c.));
- Fig. 11: die Hellfeld-Maske der Fig. 9 mit zusätzlich eingezeichneten Außenumrandungen um zusammenhängende Bereiche und Überlappungsbereiche;
- Fig. 12: ein Ausschnitt einer mit einer Hellfeld-Phasenmaske zu fertigenden Gate-Ebene.

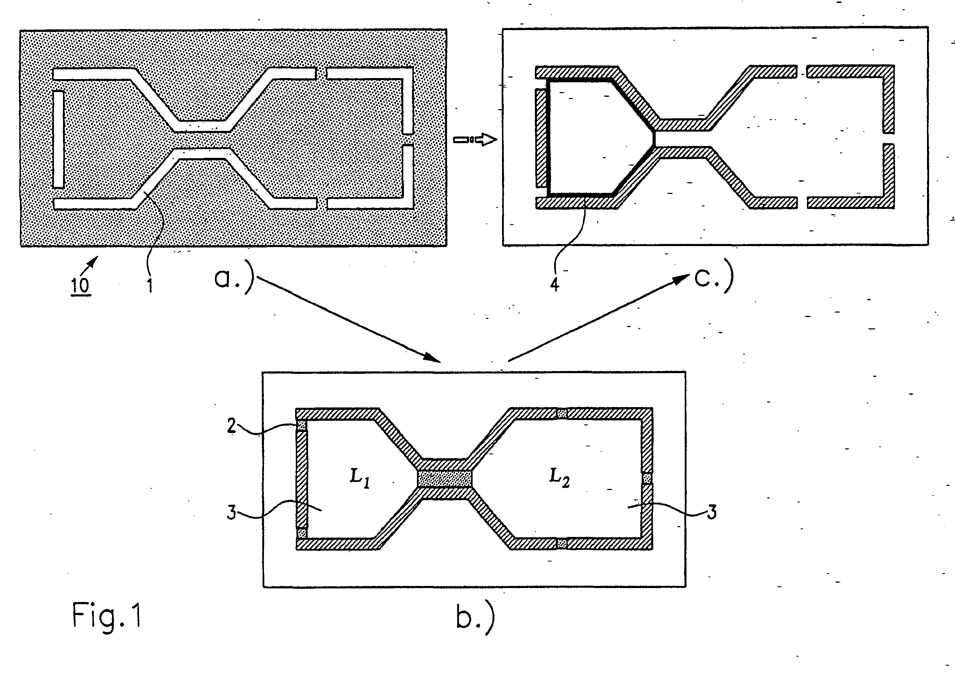

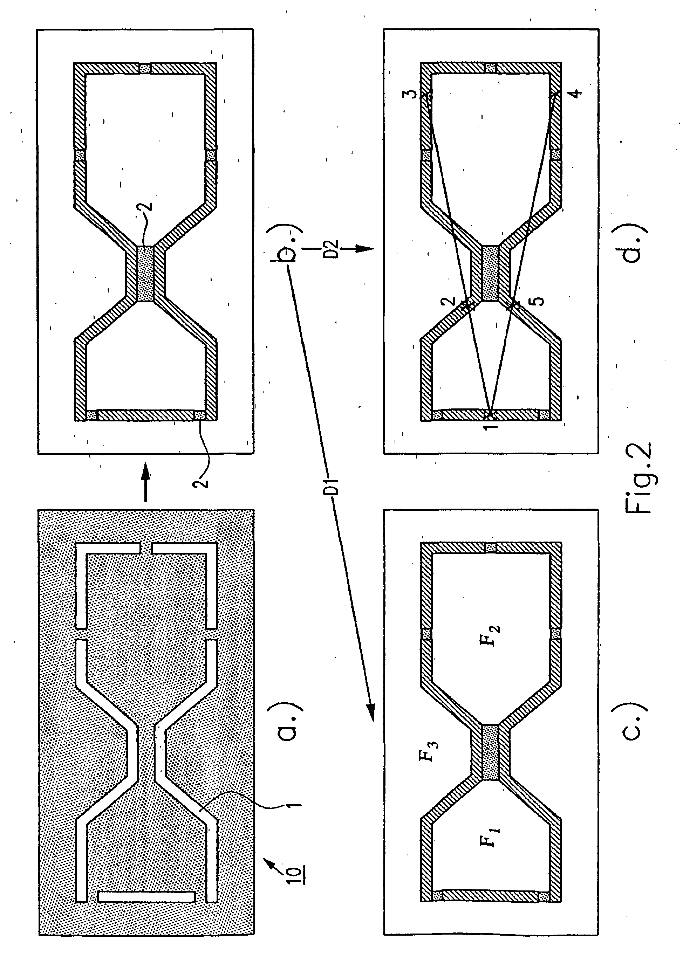

In den Figuren 1 und 2 werden anhand ein und derselben Dunkelfeld-Maskenstruktur die Unterschiede zwischen bekannten Verfahren zur Feststellung von Phasenkonflikten (Fig. 2) und dem'erfindungsgemäßen Verfahren (Fig. 1) dargestellt.

Eine Dunkelfeld-Maske 10 weist durchsichtige Bereiche 1 auf, die in elektrische Schaltungselemente wie Leiterbahnen oder dergleichen abzubilden sind.

In Fig. 2b sind die durchsichtigen Bereiche als schraffierter Polygonzug dargestellt. Zwischen den einzelnen Abschnitten des Polygonzuges befinden sich kritische Bereiche 2, in denen der Abstand zwischen einzelnen Abschnitten des Polygonzuges einen vorgegebenen Mindestwert unterschreitet. Die Aufgabe besteht darin, den einzelnen Abschnitten des Polygonzuges die Phasen zuzuweisen, welche eine Phasendifferenz Δφ = 180° aufweisen.

Ausgehend von der Fig. 2b führt das Verfahren gemäß der Druckschrift D1 (US-PS-5,923,566) zur Festlegung freier Räume F₁, F₂ und F₃, wie in Fig. 2c dargestellt ist. Die freien Räume F₁ und F₃ zeigen dabei denselben durch F₁ bestimmten elementaren Phasenkonflikt an. F₃ setzt sich zusammen aus F₁ und F₂, wobei F₂ aufgrund seiner geraden Anzahl der Wechselwirkungen (4) keinen Phasenkonflikt darstellt. Es wird somit ein und derselbe Phasenkonflikt unnötigerweise zweifach angezeigt.

Das in der eingangs genannten Druckschrift (D2) (Moniwa et al.) beschriebene Verfahren ist in Fig. 2d dargestellt und liefert die drei Zyklen (1251), (123451) und (23452). Unter diesen Zyklen weisen nur die beiden erstgenannten eine ungerade Anzahl von Knoten auf und stellen dementsprechend zwei Phasenkonflikte dar. Der zweitgenannte Zyklus setzt sich aus den beiden anderen elementaren Zyklen zusammen. Da der dritte Zyklus eine geradzahlige Anzahl von Knoten aufweist, existiert in Wirklichkeit nur ein Phasenkonflikt, der durch den ersten elementaren Zyklus bestimmt ist und unnötigerweise mit dem zweiten Zyklus doppelt angedeutet ist.

Demgegenüber werden bei dem erfindungsgemäßen Verfahren nach Bestimmung der kritischen Bereiche 2 außerhalb der durchsichtigen und der kritischen Bereiche 1 und 2 liegende zusammenhängende Bereiche 3 bestimmt, die in Fig. 1b als Flächen L₁ und L₂ bezeichnet sind. Diese Flächen werden nachfolgend auch als Länder bezeichnet. Anschließend werden die Außenumrandungen 4 dieser Länder bestimmt und deren Wechselwirkungen bzw. Berührungsstrecken mit den kritischen Bereichen 2 ermittelt. Wie in Fig. 1c zu sehen ist, gibt die Außenumrandung des Landes L₁ den einzigen erwarteten Phasenkonflikt effizienterweise eindeutig wieder. Der lokalisierte Phasenkonflikt ist durch die als Polygonzug in Fig. 1c dargestellte Außenumrandung 4 visualisiert. Die Außenumrandung um das Land L₂ zeigt dagegen keinen Phasenkonflikt an, da die Anzahl der Berührungsstrecken mit kritischen Bereichen 2 gerade (4) ist.

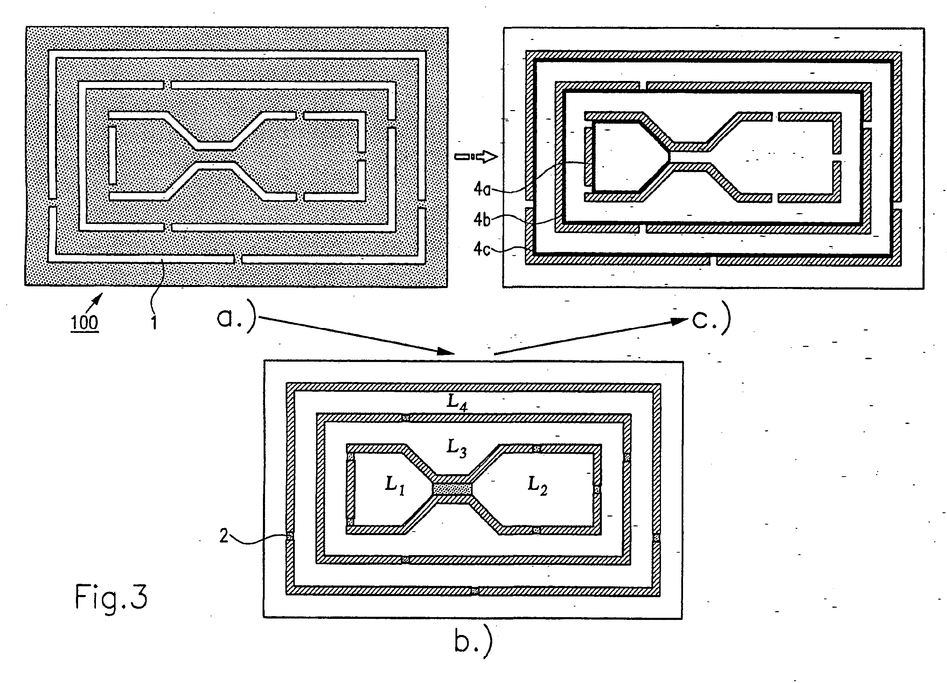

In der Fig. 3 ist eine komplexere Dunkelfeld-Maske 100 dargestellt, mit der die Unzulänglichkeit des in der Druckschrift D1 beschriebenen Verfahrens im Vergleich mit der vorliegenden Erfindung dargestellt wird. Zunächst werden gemäß Fig. 3b die durchsichtigen Bereiche 1 in Form von Polygonzügen dargestellt und kritische Bereiche 2 zwischen ihnen bestimmt. Dann werden die Länder L₁ bis L₄ wie dargestellt festgelegt. Gemäß Fig. 3c zeigen diejenigen Außenkonturen 4a, 4b und 4c der Länder, die eine ungeradzahlige Anzahl von Berührungsstrecken mit kritischen Bereichen 2 aufweisen, die lokalisierten Phasenkonflikte an. Im vorliegenden Fall wird mit dem Verfahren der Druckschrift D1 der durch die Außenumrandungen von L₃ lokalisierte Phasenkonflikt nicht erfaßt. Der Grund hierfür ist, daß dieser verschachtelte Phasenkonflikt durch zwei freie Räume, nämlich die Länder L₃ und L₄ mit geraden Zahlen von Wechselwirkungen 8 bzw. 6 eingegrenzt wird. Dieses Beispiel zeigt also die Zuverlässigkeit des erfindungsgemäßen Verfahrens gegenüber dem Verfahren der D1 hinsichtlich Dunkelfeld-Masken.

Die vorstehend beschriebenen Dunkelfeld-Masken sind so geformt, daß die kritischen Bereiche rechteck- oder allgemeiner gesagt trapezförmige Abschnitte unterschiedlicher Länge sind, die sich entlang einer Richtung erstrecken. Es kann jedoch auch der Fall auftreten, daß zwei oder mehr derartige trapezförmige, gerade Abschnitte, die sich in unterschiedliche Richtungen erstrecken, aufeinander stößen. In diesem Fall kommt zu der Bestimmung von Ländern die Bestimmung von Überlappungsbereichen zwischen diesen trapezförmigen geraden Abschnitten hinzu.

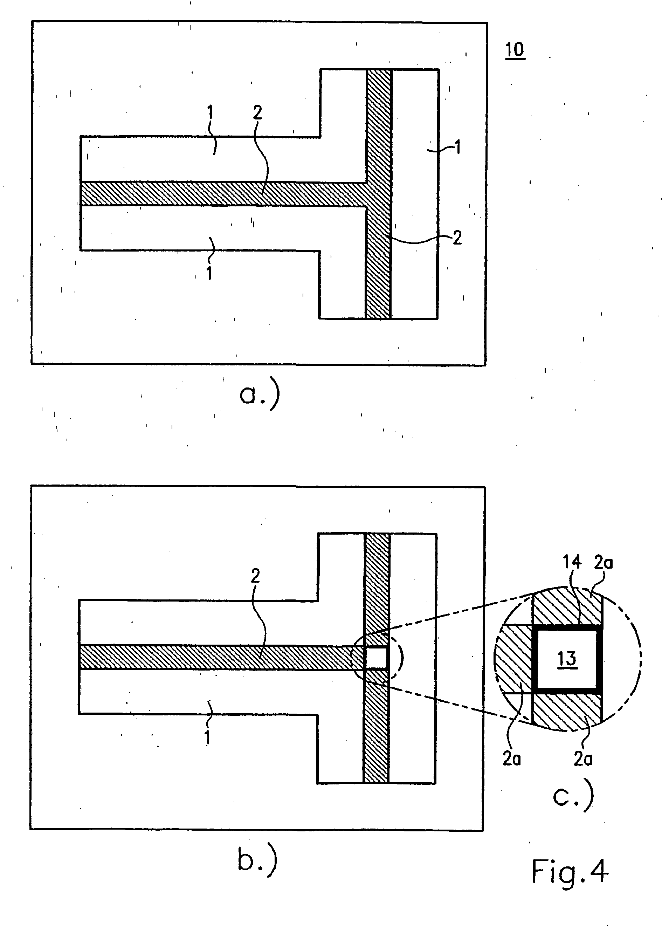

Ein Beispiel für eine derartige Phasenmaske ist in der Fig. 4 dargestellt. Auf dieser Phasenmaske 10 sind drei durchsichtige Bereiche 1 derart relativ zueinander angeordnet, daß kritische Bereiche 2 entstehen, innerhalb derer die durchsichtigen Bereiche 1 einen vorgegebenen Mindestabstand voneinander unterschreiten. Die kritischen Bereiche 2 bilden ein T-förmiges Gebilde, bei welchem also zwei rechteckförmige, gerade Abschnitte aufeinander zulaufen und einen Überlappungsbereich 13 bilden. Der Überlappungsbereich 13 wird dadurch bestimmt, daß die sich kreuzenden geraden Abschnitte über die Punkte, an denen sie aneinander stoßen, hinausgezeichnet werden, wobei der von den gezeichneten Fortsetzungslinien gemeinsam umschlossene Bereich oder die Schnittmenge der gezeichneten Fortsetzungslinien den Überlappungsbereich 13 de-13 definiert. Zur Ermittlung des entarteten kritischen Bereiches wird von dem kritischen Bereich 2 der Überlappungsbereich 13 abgezogen. Die Außenumrandung 14 um den Überlappungsbereich 13 weist, somit drei Berührungsstrecken mit den drei entarteten kritischen Bereichen 2a auf und signalisiert damit aufgrund der ungeraden Anzahl der Berührungsstrecken einen Phasenkonflikt.

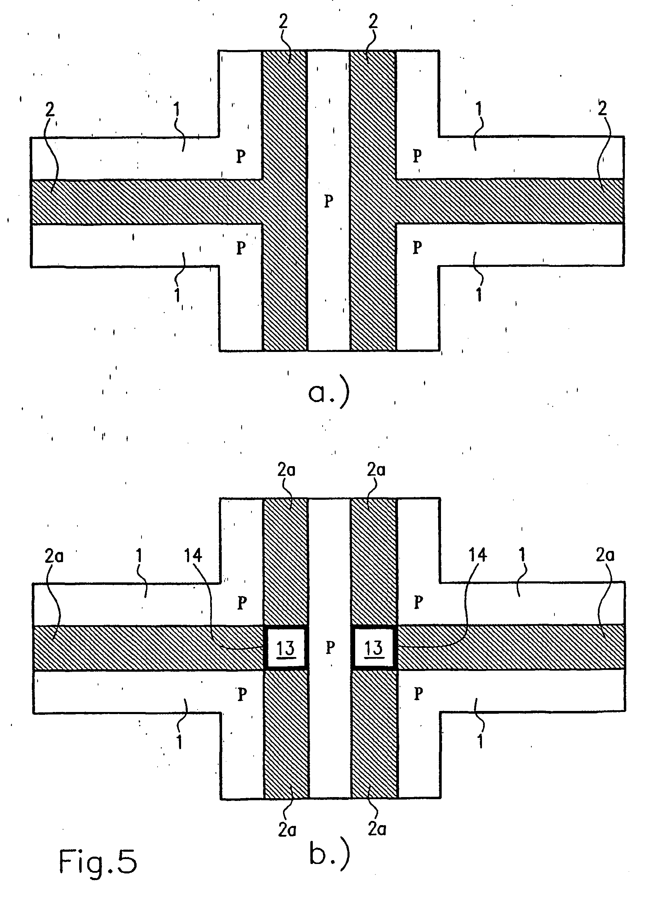

In der Fig. 5 ist im oberen Teilbild a.) eine weitere Dunkelfeld-Maskenstruktur dargestellt, welche im Vergleich mit der in der Fig. 4 gezeigten einfachen T-Struktur eine zweifache T-Struktur (2T-Struktur) zeigt. Gemäß dem unteren Teilbild b.) werden zwei Überlappungsbereiche 13 ermittelt und diese von den kritischen, undurchsichtigen Bereichen 2 abgezogen, woraus sich die entarteten kritischen Bereiche 2a ergeben. Die Außenumrandungen 14 um die Überlappungsbereiche 13 weisen jeweils drei Berührungsstrecken mit Endabschnitten gerader, entarteter kritischer Bereiche 2a auf, so daß dadurch zwei Phasenkonflikte angezeigt werden. Dieser zweifache Phasenkonflikt kann mit der Methode des bereits genannten US-Patents 5,923,566 nicht erfaßt werden.

Bei den Dunkelfeld-Masken der Figuren 1 bis 3 existieren keine derartigen Überlappungsbereiche 13. Somit sind in diesen Fällen die kritischen Bereiche identisch mit den entarteten kritischen Bereichen.

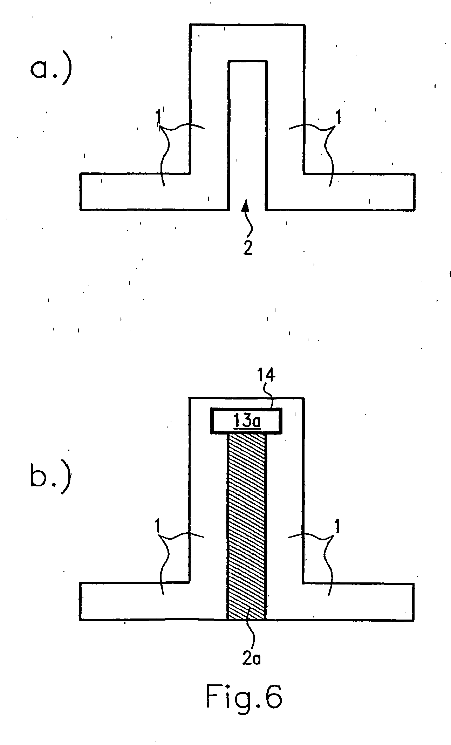

In den Figuren 6a,b ist eine weitere Dunkelfeld-Maske dargestellt, in der ein weiterer Bereichstyp enthalten ist, der einen Phasenkonflikt beinhaltet.

In der Fig.6a ist zunächst die Dunkelfeld-Maskenstruktur dargestellt, welche einen zusammenhängenden durchsichtigen Bereich 1 aufweist, der beispielsweise eine von der Phasenmaske abzubildende Leiterbahnstruktur darstellt und von undurchsichtigem Gebiet umgeben ist. Der durchsichtige Bereich 1 ist so geformt, daß er zwischen zwei Streckenabschnitten einen kritischen, undurchsichtigen Bereich 2 umschließt, der eine vorgegebene Strukturgröße unterschreitet. Dieser kritische Bereich 2 endet somit inmitten eines Gebiets bestehend aus dem durchsichtigen Bereich 1. In diesem Fall ist ein sogenannter Endbereich 13a zu erzeugen. Der Endbereich 13a wird dadurch generiert, indem eine den kurzen Seitenrand des Endabschnitts des kritischen Bereichs 2 überlagernde Linie um einen infinitesimal kleinen Betrag nach außen expandiert wird ("Sizing-Operation"). Um diesen Endbereich 13a wird dann eine Außenumrandung 14 gezogen,

Anschließend werden wieder wie erwähnt entartete kritische Bereiche 2a durch Abziehen von eventuell vorhandenen Überlappungsbereichen 13 von den kritischen Bereichen 2 generiert. Da im vorliegenden Fall der kritische Bereich 2 keinen Überlappungsbereich 13 enthält, wird aus ihm ohne Veränderung ein entarteter kritischer Bereich 2a (schraffiert) generiert. Die Außenumrandung 14 weist somit eine Berührungsstrecke mit dem entarteten kritischen Bereich 2a auf, so daß wegen der ungeraden Anzahl von Berührungsstrecken ein Phasenkonflikt durch sie angezeigt wird.

Im folgenden werden Ausführungsbeispiele gemäß einem zweiten Aspekt des erfindungsgemäßen Verfahrens hinsichtlich der Anwendung auf Hellfeld-Masken dargestellt.

In Fig. 7a ist ein einfaches Ausführungsbeispiel für eine Hellfeld-Maskenstruktur 20 dargestellt, welche undurchsichtige Bereiche 21 vor einem durchsichtigen Hintergrund enthält. Gemäß Fig. 7b werden zunächst phasenverschiebende Elemente 22 (schraffiert dargestellt) beidseits der undurchsichtigen, kritischen Bereiche 21 festgelegt. Als kritische Bereiche 21 gelten solche Bereiche, die eine bestimmte, vorgegebene Mindestbreite oder Mindeststrukturgröße unterschreiten. Die Festlegung dieser phasenverschiebenden Elemente kann beispielsweise wie in der US-PS-5,537,648 (Fig. 6 und zugehöriger Beschreibungstext) erfolgen.

Anschließend werden gemäß Fig. 7c in ebensolcher Weise wie bereits im Zusammenhang mit der Dunkelfeld-Maske der Fig.5 beschrieben. Überlappungsbereiche 23 zwischen geraden Abschnitten der kritischen Bereiche 21 festgestellt. Diese werden wie folgt bestimmt.

Es kann der Fall auftreten, daß zwei oder mehr trapezförmige, gerade Abschnitte, die sich in unterschiedliche Richtungen erstrecken, aufeinander stoßen. In diesem Fall ist die Bestimmung von Überlappungsbereichen zwischen diesen trapezförmigen geraden Abschnitten von Bedeutung. Ein Beispiel hierfür ist das in der Fig.7e vergrößert dargestellte T-förmige Gebilde. Die undurchsichtigen Bereiche 21 bilden eine T-förmige Verzweigungsstruktur, bei welcher also zwei in diesem Beispiel rechteckförmige, gerade Abschnitte aufeinander zulaufen und einen Überlappungsbereich 23 bilden. Der Überlappungsbereich 23 kann beispielsweise dadurch definiert werden, daß die sich kreuzenden geraden Abschnitte über die Punkte, an denen sie aneinander stoßen, hinausgezeichnet werden, wobei der von den Fortsetzungslinien gemeinsame eingeschlossene Bereich oder die Schnittmenge der gezeichneten Fortsetzungslinien den Überlappungsbereich 23 definieren. Zur Ermittlung des entarteten kritischen Bereiches wird von den undurchsichtigen kritischen Bereichen 21 der Überlappungsbereich 23 abgezogen. Die Außenumrandung 24 um den Überlappungsbereich 23 weist somit drei Berührungsstrecken mit den drei entarteten kritischen Bereichen 21a auf und signalisiert damit aufgrund der ungeraden Anzahl der Berührungsstrecken einen Phasenkonflikt.

Durch Abziehen der Überlappungsbereiche 23 von den kritischen Bereichen 21 werden entartete kritische Bereiche 21a generiert. Dann werden große Außenumrandungen 24 zu den Überlappungsbereichen 23 und Ländern generiert, wie in dem kreisförmigen Ausschnitt e) aus Fig. 7d) zu sehen ist. Ein Phasenkonflikt liegt genau dann vor, wenn eine Außenumrandung 24 eine ungerade Zahl von Wechselwirkungen bzw. Berührungsstrecken mit entarteten kritischen Bereichen 21a aufweist. Gemäß dem Ausschnitt e) steht die Außenumrandung 24 um den Überlappungsbereich 23 mit den drei entarteten kritischen Bereichen 21a in Berührung und signalisiert somit in eindeutiger Weise einen T-Phasenkonflikt.

Dieser Phasenkonflikt wird durch das Verfahren gemäß der Druckschrift D2 nicht erfaßt, denn bei Anwendung des ungerichteten Konfliktgraphs ergibt sich kein Zyklus, da nämlich nur zwei phasenverschiebende Elemente und eine zusammenhängende kritische Struktur vorhanden sind.

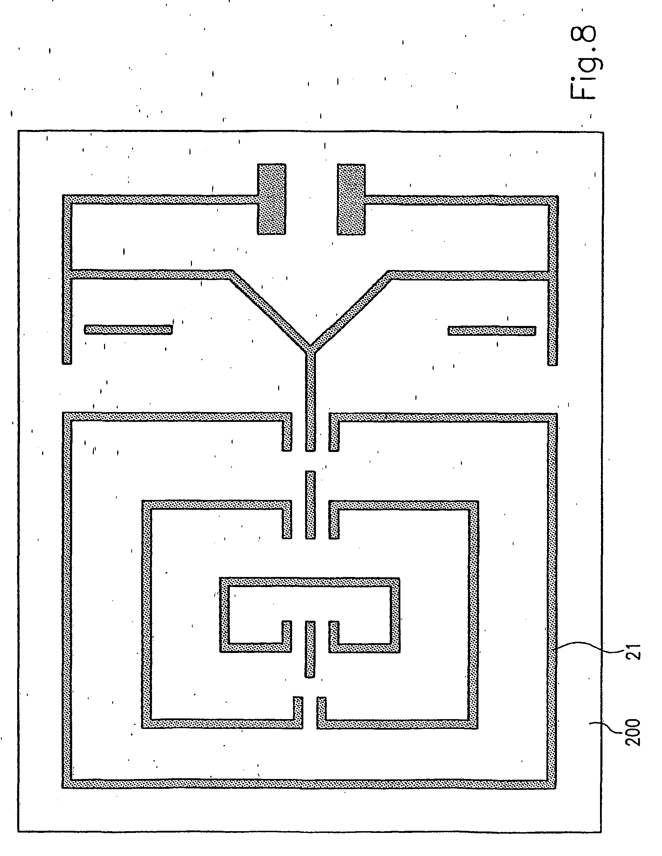

In den Figuren 8 bis 11 wird die Wirkungsweise des erfindungsgemäßen Verfahrens gemäß seinem zweiten Aspekt anhand einer komplexeren Hellfeld-Maskenstruktur verdeutlicht.

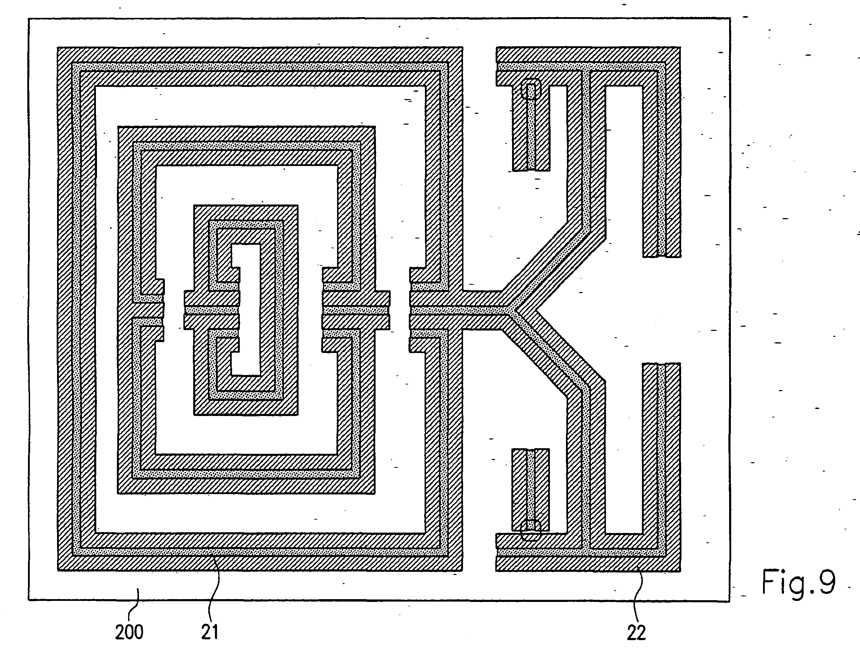

In der Fig. 8 ist zunächst eine Hellfeld-Maske 200 mit undurchsichtigen Bereichen 21 dargestellt, die in Schaltungselemente wie Leiterbahnen oder dergleichen abzubilden sind. Gemäß Fig. 9 werden wie bereits erläutert beidseits der geraden Abschnitte der undurchsichtigen Bereiche 21 phasenverschiebende Elemente 22 (schraffierte Polygone) bestimmt, da die undurchsichtigen Bereiche 21 als kritisch eingestuft werden.

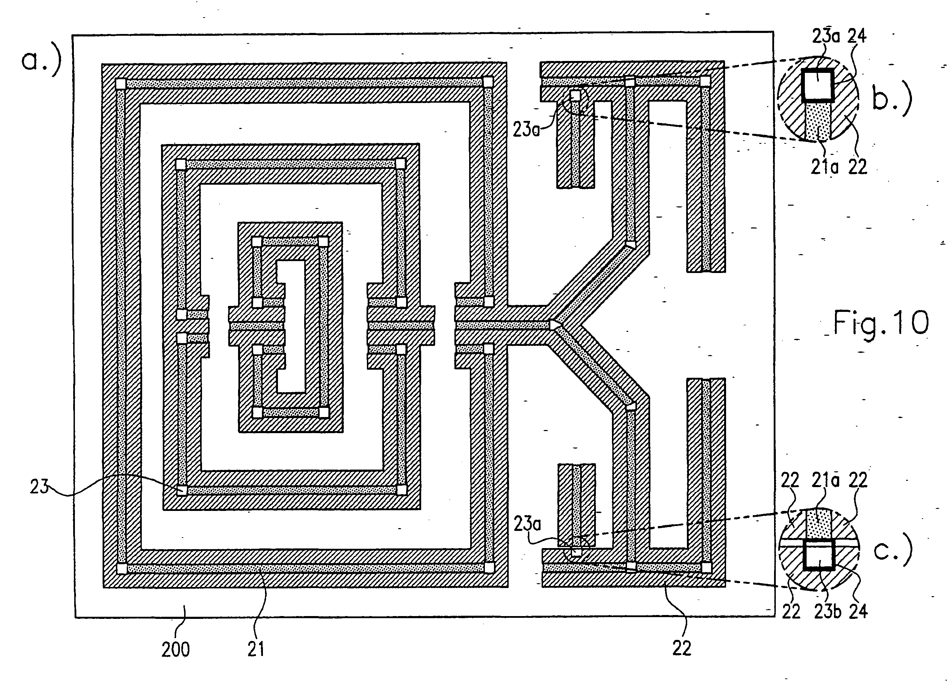

Bei dieser Hellfeld-Maske 200 tritt zusätzlich zu den Ländern und den Überlappungsbereichen 23 zwei weitere Typen von Bereichen hinzu. Immer dann, wenn gerade Abschnitte der undurchsichtigen Bereiche 21 inmitten eines phasenverschiebenden Elements 22 enden, ist ein sogenannter Endbereich 23a zu generieren. Dieser wird einfach dadurch erzeugt, daß, wie in dem kreisförmig vergrößerten Ausschnitt b) aus Fig. 10a gezeigt, eine den kurzen Seitenrand des Endabschnitts des undurchsichtigen Bereichs 21 überlagernde Linie um einen infinitesimal kleinen Betrag nach außen expandiert wird ("Sizing-Operation"). Um diesen Endbereich 23a wird dann eine Außenumrandung 24 gezogen, die den kurzen Seitenrand des Endabschnitts des undurchsichtigen Bereichs 21 berührt. Weiter ist - wie in dem kreisförmig vergrößerten Ausschnitt c.) aus Fig. 10a zu sehen - ein Endbereich 23b dort zu generieren, wo ein kritischer Bereich 21 an einem kritischen Wechselwirkungsbereich endet. Kritische Wechselwirkungsbereiche sind Bereiche zwischen phasenverschiebenden Elementen 22, in denen ein vorgegebener Abstand zwischen den phasenverschiebenden Elementen 22 unterschritten wird. Der Endbereich 23b wird ebenfalls durch eine "Sizing-Operation" dadurch erzeugt, daß, wie in dem kreisförmig vergrößerten Ausschnitt c) aus Fig. 10a gezeigt, eine den kurzen Seitenrand des Endabschnitts des undurchsichtigen Bereichs 21 überlagernde Linie um einen infinitesimal kleinen Betrag nach außen expandiert wird. Eine um diesen Endbereich 23b gezogene Außenumrandung 24 berührt somit den kurzen Seitenrand des Endabschnitts des undurchsichtigen Bereichs 21.

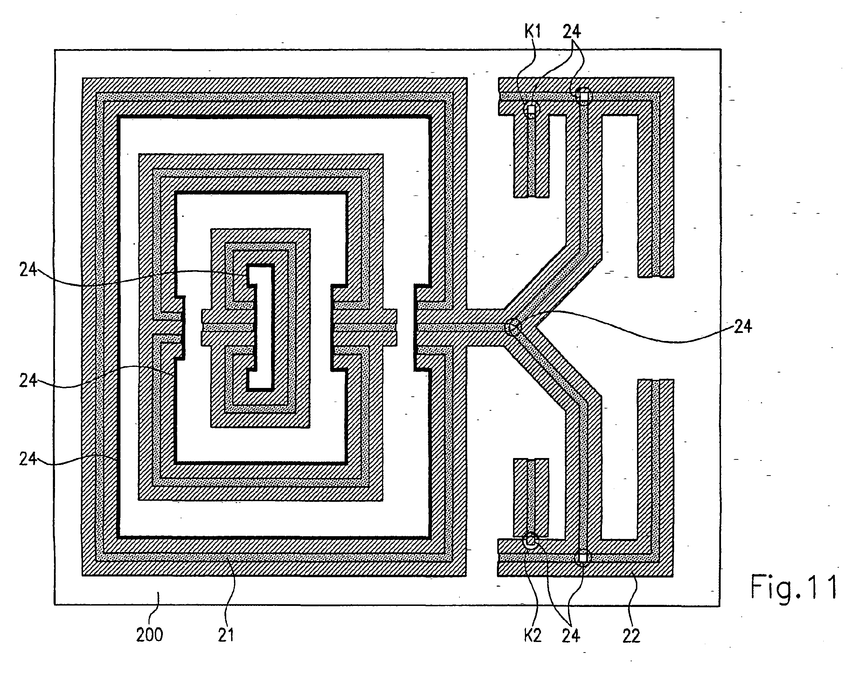

Gemäß Fig. 10 werden also Überlappungsgebiete 23 zwischen geraden Abschnitten der undurchsichtigen Bereiche 21 und Endbereiche 23a,b von geraden Abschnitten, die inmitten eines phasenverschiebenden Elements 22 oder eines Wechselwirkungsbereichs enden, bestimmt. Dann werden entartete kritische Bereiche durch Abziehen der Überlappungsbereiche 23 von den undurchsichtigen Bereichen 21 definiert. Phasenkonflikte werden gemäß Fig. 11 durch solche große Außenumrandungen 24 von Ländern, Überlappungsbereichen 23 oder Endbereichen 23a,b angezeigt, die mit einer ungeraden Zahl von Endabschnitten der aus den undurchsichtigen Maskenfeldern 21 abgeleiteten entarteten kritischen Bereiche in Berührung treten. Endbereiche 23a,b signalisieren somit stets einen Phasenkonflikt, da sie mit genau einem Endabschnitt des undurchsichtigen Bereichs 21 in Berührung treten. In Fig. 11 sind somit die acht eindeutig lokalisierten Phasenkonflikte 24 zu der Hellfeld-Maskenstruktur der Fig.8 anhand der acht dunklen Außenumrandungen 24 zu sehen. Der zweite, auf der linken Seite des Bildes, verschachtelte Phasenkonflikt läßt sich mit dem Verfahren der D1 nicht erfassen, da den zwei an ihn angrenzenden freien Räumen gerade Zahlen der Wechselwirkungen 6 und 4 zugeordnet werden. Es gibt somit zwei Typen von sogenannten Endbereichskonflikten K1 und K2.'Ein Endbereichskonflikt liegt genau dann vor, wenn die entsprechende Linie inmitten eines phasenverschiebenden Elements 22 (K1) oder eines kritischen Wechselwirkungsbereiches zwischen zwei phasenverschiebenden Elementen 22 (K2) endet. Diese zwei Typen von Endbereichskonflikten sind in der Fig. 11 eingezeichnet.

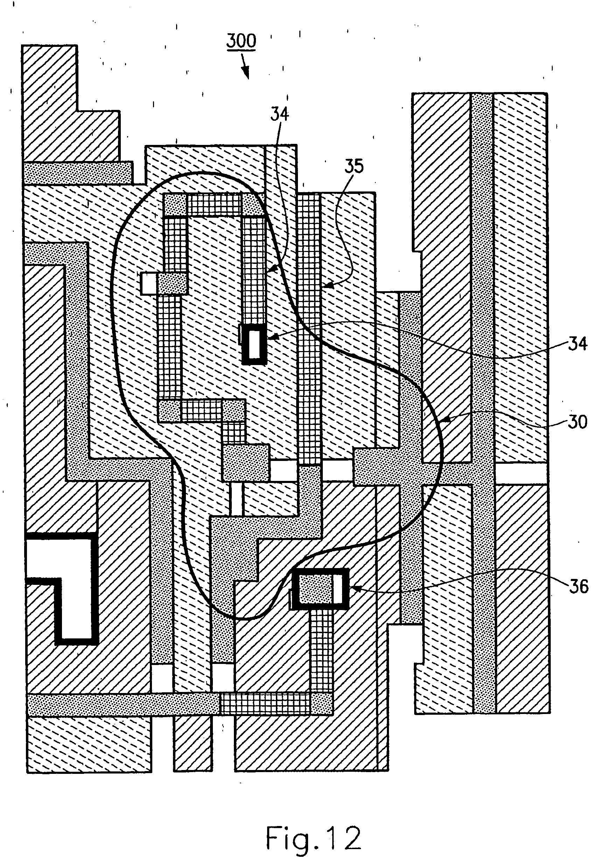

In Fig. 12 ist ein Ausschnitt einer Gate-Ebene dargestellt, welche mit einer Hellfeld-Phasenmaske gefertigt werden soll. Die darin dargestellten Leiterbahnen minimaler Breite sind kritische Strukturen und müssen daher mittels beidseitig angeordneter Phasenelemente realisiert werden, während die Aufweitungen (Kontaktflecken bez. landing pads) keine kritischen Breiten aufweisen.

Beidseits der Leiterbahnen sind erzeugte phasenschiebende Elemente dargestellt, welche die zwei verschiedenen Phasen 0° und 180° aufweisen und dementsprechend mit zwei verschiedenen Schraffuren gekennzeichnet sind. Schachbrettartig markiert sind die Teile von Leiterbahnen (in diesem Fall sind es Gates), die bei der vorgelegten Phasenzuweisung nicht korrekt abgebildet werden können, da beide Seiten des Gates mit derselben Phase belichtet werden. In der Figur sind sie als innerhalb der Umrandung 30 liegende Phasenkonflikte 34 und 35 bezeichnet. Ein weiterer Phasenkonflikt 36 liegt außerhalb der Umrandung 30.

Die Ursache für den linken der beiden nicht lokalisierten Phasenkonflikte ist darin zu sehen, daß das betroffene Gate an beiden Seiten an denselben Phasenschieber angrenzt. Die Ursache des rechten Phasenkonflikts ist nicht so einfach zu sehen. Es stellt sich die Frage, warum keine Phasenzuweisung gefunden werden kann, die diesen Phasenkonflikt vermeidet. Die Ursache liegt in dem Zyklus, den die Umrandung 30 zeigt. Entlang diesem Pfad sind fünf kritische Gates und lückenlos fünf Phasenschieber aufgereiht. Die von diesem Pfad getroffenen Phasenschieber können nicht abwechselnd beiden Phasen zugewiesen werden. Mit Hilfe der Umrandung 30 ist diese Tatsache einfach nachvollziehbar. Erst durch das erfindungsgemäße Verfahren wird aber klar angezeigt, daß in dem diskutierten Teil des Ausschnittes tatsächlich nur ein und nicht zwei Phasenkonflikte vorliegen.

In einer praktischen Anwendung des erfindungsgemäßen Verfahrens können die ermittelten Phasenkonflikte auf einem Anzeigegerät wie einem Bildschirm durch Aufhellen (Highlighten) der den Phasenkonflikten entsprechenden Polygone bzw. großen Außenumrandungen sichtbar gemacht werden.

## Patentansprüche

1. Verfahren zur Feststellung der Abbildbarkeit integrierter Halbleiterschaltkreise auf alternierende Dunkelfeld-Phasenmasken und zur Feststellung möglicher Phasenkonflikte, wobei elektrische Schaltungselemente wie Leiterbahnen und dergleichen in durchsichtige Bereiche (1) der Phasenmaske abzubilden sind, bei welchem Verfahren
a) kritische Bereiche (2) bestimmt werden, in welchen jeweils zwei für die Phasenmaske vorgesehene benachbarte durchsichtige Bereiche (1) einen bestimmten vorgegebenen Mindestabstand voneinander unterschreiten;
b) Überlappungsbereiche (13) zwischen geraden Abschnitten der erhaltenen kritischen Bereiche (2) und Endbereiche (13a) von inmitten von durchsichtigen Bereichen endenden geraden Abschnitten der kritischen Bereiche (21) sowie durch Abziehen der Überlappungsbereiche (13) von den kritischen Bereichen (2) entartete kritische,'Bereiche (2a) bestimmt werden;
c) außerhalb der durchsichtigen (1) und der kritischen Bereiche (2) liegende zusammenhängende Bereiche (3) sowie die großen Außenumrandungen (4) dieser zusammenhängenden Bereiche (3), der Überlappungsbereiche (13) und der Endbereiche (13a) bestimmt werden;
d) von jeder bestimmten großen Außenumrandung (4) jedes zusammenhängenden Bereiches (3), jedes Überlappungsbereiches (13) und jedes Endbereiches (13a) die Anzahl der Berührungsstrecken mit den entarteten kritischen Bereichen (2a) bestimmt und bei ungerader Anzahl ein Phasenkonflikt festgestellt wird.

2. Verfahren zur Feststellung der Abbildbarkeit integrierter Halbleiterschaltkreise auf alternierende Hellfeld-Phasenmasken und zur Feststellung möglicher Phasenkonflikte, wobei elektrische Schaltungselemente wie Leiterbahnen und dergleichen in undurchsichtige Bereiche (21) der Phasenmaske abzubilden sind, bei welchem Verfahren
a.) phasenverschiebende Bereiche (22) jeweils beidseits von für die Phasenmaske vorgesehenen undurchsichtigen, kritischen Bereichen (21) bestimmt werden;
b.) Überlappungsbereiche (23) zwischen geraden Abschnitten der kritischen Bereiche (21) und Endbereiche (23a,b) von inmitten von phasenverschiebenden Bereichen (22) oder kritischen Wechselwirkungsbereichen zwischen phasenverschiebenden Bereichen (22) endenden geraden Abschnitten der kritischen Bereiche (21) sowie durch Abziehen der Überlappungsbereiche (23) von,den kritischen Bereichen (21) entartete kritische Bereiche (21a) bestimmt werden;
c.) außerhalb der phasenverschiebenden Bereiche (22) und der kritischen Bereiche (21) liegende zusammenhängende Bereiche bestimmt werden und die großen Außenumrandungen (24) der zusammenhängenden Bereiche, der Überlappungsbereiche (23) und der Endbereiche (23a,b) bestimmt werden; und
d.) von jeder erhaltenen Außenumrandung (24) jedes zusammenhängenden Bereiches, jedes Überlappungsbereiches (23) und jedes Endbereiches (23a,b) die Anzahl der Berührungsstrecken mit den entarteten kritischen Bereichen (21a) bestimmt und bei ungerader Anzahl ein Phasenkonflikt festgestellt wird.

3. Verfahren nach Anspruch 1,
**dadurch gekennzeichnet, daß**
- die Phasenkonflikte **dadurch** gelöst werden, daß einem durchsichtigen Bereich (1) zwei verschiedene Phasen mit einer Phasendifferenz Δφ = 180° zugewiesen werden, und
- ein weiterer Belichtungsschritt durchgeführt wird, bei welchem die Grenzlinie zwischen den beiden Phasengebieten belichtet wird.

4. Verfahren nach Anspruch 2,
**dadurch gekennzeichnet, daß**
- die Phasenkonflikte **dadurch** gelöst werden, daß einem zu bestimmenden phasenverschiebenden Element (22) zwei verschiedene Phasen mit einer Phasendifferenz Δφ = 180° zugewiesen werden, und
- ein weiterer Belichtungsschritt durchgeführt wird, bei welchem die Grenzlinie zwischen den beiden Phasengebieten belichtet wird.

5. Verfahren nach einem oder mehreren der vorhergehenden Ansprüche,
**dadurch gekennzeichnet, daß**
- die Phasenkonflikte durch Verändern der Schaltkreisstruktur gelöst werden.

6. Verfahren nach einem oder mehreren der Ansprüche 1 bis 4,
**dadurch gekennzeichnet, daß**
- die Phasenkonflikte durch Einsatz von mehr als zwei verschiedenen Phasen (Multiphasen) gelöst werden.

7. Verfahren nach einem der vorhergehenden Ansprüche,
**dadurch gekennzeichnet, daß**
- die Phasenkonflikte an einem Anzeigegerät wie einem Bildschirm durch Aufhellen der den Phasenkonflikten entsprechenden Polygone bzw. großen Außenkonturen sichtbar gemacht werden.

## Claims

1. Method for determining the ability to project images of integrated semiconductor circuits onto alternating dark-field phase masks and for determining possible phase conflicts, the intention being to project images of electrical circuit elements such as interconnects and the like into transparent regions (1) of the phase mask, in which method
a) critical regions (2) are determined in which in each case two adjacent transparent regions (1) provided for the phase mask fall below a specific predetermined minimum distance from one another;
b) overlap regions (13) between straight sections of the critical regions (2) obtained and end regions (13a) of straight sections of the critical regions (21), which straight sections end in the midst of transparent regions, and, by subtracting the overlap regions (13) from the critical regions (2), degenerate critical regions (2a) are determined;
c) contiguous regions (3) lying outside the transparent (1) and the critical regions (2) and the large outer boundaries (4) of said contiguous regions (3), of the overlap regions (13) and of the end regions (13a) are determined;
d) from each large outer boundary (4) determined for each contiguous region (3), each overlap region (13) and each end region (13a), the number of stretches of contact with the degenerate critical regions (2a) is determined and, in the event of an odd number, a phase conflict is determined.

2. Method for determining the ability to project images of integrated semiconductor circuits onto alternating bright-field phase masks and for determining possible phase conflicts, the intention being to project images of electrical circuit elements such as interconnects and the like into nontransparent regions (1) of the phase mask, in which method
a.) phase-shifting regions (22) are determined in each case on both sides of nontransparent, critical regions (21) provided for the phase mask;
b.) overlap regions (23) between straight sections of the critical regions (21) and end regions (23a, b) of straight sections of the critical regions (21), which straight sections end in the midst of phase-shifting regions (22) or critical interaction regions between phase-shifting regions (22), and, by subtracting the overlap regions (23) from the critical regions (21), degenerate critical regions (21a) are determined;
c.) contiguous regions lying outside the phase-shifting regions (22) and the critical regions (21) are determined and the large outer boundaries (24) of the contiguous regions, of the overlap regions (23) and of the end regions (23a, b) are determined; and
d.) from each outer boundary (24) obtained for each contiguous region, each overlap region (23) and each end region (23a, b), the number of stretches of contact with the degenerate critical regions (21a) is determined and, in the event of an odd number, a phase conflict is determined.

3. Method according to Claim 1,
**characterized in that**
- the phase conflicts are resolved by allocating two different phases with a phase difference Δφ = 180° to a transparent region (1), and
- a further exposure step is carried out, in which the boundary line between the two phase regions is exposed.

4. Method according to Claim 2,
**characterized in that**
- the phase conflicts are resolved by allocating two different phases with a phase difference Δφ = 180° to a phase-shifting element (22) to be determined, and
- a further exposure step is carried out, in which the boundary line between the two phase regions is exposed.

5. Method according to one or more of the preceding claims,
**characterized in that**
- the phase conflicts are resolved by altering the circuit structure.

6. Method according to one or more of Claims 1 to 4,
**characterized in that**
- the phase conflicts are resolved by using more than two different phases (multiphases).

7. Method according to one of the preceding claims,
**characterized in that**
- the phase conflicts are visualized on a display device such as a screen by highlighting the polygons or large outer contours which correspond to the phase conflicts.

## Revendications

1. Procédé de constatation de la reproductibilité de circuits intégrés à semi-conducteur sur des masques de phase alternés à champ noir et de constatation de conflits éventuels de phase, dans lequel on reproduit des éléments de circuit électrique, comme des pistes conductrices et analogues, dans des parties (1) transparentes du masque de phase, procédé dans lequel
a) on détermine des parties (2) critiques dans lesquelles, respectivement deux parties (1) transparentes voisines, prévues pour le masque de phase sont à une distance l'une de l'autre inférieure à une certaine distance minimum prescrite ;
b) on détermine des parties (13) de chevauchement entre des tronçons rectilignes des parties (2) critiques obtenues et des parties (13a) d'extrémité de tronçons rectilignes, se terminant au milieu de parties transparentes, des parties (21) critiques ainsi qu'en soustrayant les parties (13) de chevauchement des parties (2a) critiques dénaturées par les parties (2) critiques;
c) on détermine des parties (3) d'un seul tenant se trouvant à l'extérieur des parties (1) transparentes et des parties (2) critiques ainsi que les grands contours (4) extérieurs de ces parties (3) d'un seul tenant, des parties (13) de chevauchement et des parties (13a) d'extrémité;
d) à partir de chaque grand contour (4) extérieur déterminé de chaque partie (3) d'un seul tenant, de chaque partie (13) de chevauchement et de chaque partie (13a) déterminée, on détermine le nombre des sections de contact avec les parties (2a) critiques dénaturées et on constate un conflit de phase si le nombre est impair.

2. Procédé de constatation de la reproductibilité de circuits intégrés à semi-conducteur sur des masques de phase alternés à champ clair et de constatation de conflits éventuels de phase, des éléments de circuit électriques comme des pistes conductrices et analogues pouvant être reproduits dans des parties (21) non transparentes du masque de phase, procédé dans lequel
a.) on détermine des parties (22) de déplacement de phase, respectivement des deux côtés de parties (21) critiques non transparentes prévues pour le masque de phase;
b.) on détermine des parties (23) de chevauchement entre des tronçons rectilignes des parties (21) critiques et des parties (23a, b) d'extrémité de tronçons droits des parties (21) critiques, se terminant au milieu de parties (22) décalées en phase ou de parties d'interaction critiques entre des parties (22) décalées en phase, ainsi qu'en soustrayant les parties (23) de chevauchement des parties (21a) critiques dénaturées en soustrayant les parties (21) critiques;
c.) on détermine des parties d'un seul tenant se trouvant à l'extérieur des parties (22) décalées en phase et des parties (21) critiques et l'on détermine les grands contours (24) extérieurs des parties d'un seul tenant, des parties (23) de chevauchement et des parties (23a, b) d'extrémité;
d.) on détermine à partir de chaque contour (24) extérieur obtenu de chaque partie d'un seul tenant, de chaque partie (23) de chevauchement et de chaque partie (23a, b) d'extrémité, le nombre des sections de contact avec les parties (21a) critiques dénaturées et si le nombre est impair on constate un conflit de phase.

3. Procédé suivant la revendication 1,
**caractérisé en ce que**
- on résout le conflit de phase en affectant à une partie (1) transparente deux phases différentes ayant une différence de phase Δφ = 180°, et
- on effectue un autre stade d'exposition, dans lequel on expose la ligne de démarcation entre les deux zones de phase.

4. Procédé suivant la revendication 2,
**caractérisé en ce que**
- on résout le conflit de phase en affectant à un élément (22) décalé en phase à déterminer deux phases différentes ayant une différence de phase Δφ = 180°, et
- on effectue un stade supplémentaire d'exposition,
dans lequel on expose la ligne de démarcation entre les deux zones de phase.

5. Procédé suivant une ou plusieurs des revendications précédentes,
**caractérisé en ce que**
- on résout les conflits de phase en modifiant la structure du circuit.

6. Procédé suivant une ou plusieurs des revendications 1 à 4,
**caractérisé en ce que**
- on résout les conflits de phase en introduisant plus de deux phases différentes (multiphases).

7. Procédé suivant une ou plusieurs des revendications précédentes,
**caractérisé en ce que**
- on rend visibles les conflits de phase sur un appareil indicateur, comme un écran, en éclaircissant les polygones ou les grands contours extérieurs correspondant aux conflits de phase.
